# EUROPEAN PATENT APPLICATION

(11) **EP 2 246 875 A1**
(43) Date of publication of application: **03.11.2010**
(21) Application number: 09712373.1
(22) Date of filing: 29.01.2009
(51) Int. Cl.: H01L 21/02, C23C 14/56, C23C 16/44, H01L 21/205, H01L 21/3065, H01L 21/677

(54) **VACUUM PROCESSING DEVICE, METHOD FOR MAINTAINING VACUUM PROCESSING DEVICE AND VACUUM PROCESSING FACTORY**

(30) Priority: 20.02.2008 JP 2008038853
(71) Applicant: Sharp Kabushiki Kaisha, Osaka-shi, Osaka 545-8522 (JP)
(72) Inventor: KISHIMOTO, Katsushi, Osaka-shi, Osaka 545-8522 (JP); FUKUOKA, Yusuke, Osaka-shi, Osaka 545-8522 (JP)
(74) Representative: Müller - Hoffmann & Partner
(86) International application number: PCT/JP2009/051415
(87) International publication number: WO 2009/104463

(57) **Abstract**

A vacuum processing device (1) includes a first processing chamber (101) for housing a workpiece (107) and performing vacuum processing on the workpiece, an evacuatable second processing chamber (102) for housing a workpiece to be vacuum-processed and a workpiece having been vacuum-processed, a gate unit (103) provided between the first and second processing chambers in such a manner that the gate unit is attachable to and detachable from the first processing chamber, a transport device (202) for loading the workpiece to be vacuum-processed, from a loading unit (108) to a vacuum processing unit (104) through the gate unit (103), and unloading the workpiece having been vacuum-processed, from the vacuum processing unit (104) to an unloading unit (119) through the gate unit (103), and a movement mechanism (200) for separating the first and second processing chambers from each other.

## Description

### TECHNICAL FIELD

The present invention relates to a vacuum processing device for performing vacuum processing on a workpiece to be processed, and a maintenance method for the vacuum processing device, and particularly to a vacuum processing device including a first processing chamber for housing a workpiece and performing vacuum processing on the workpiece, and an evacuatable second processing chamber for housing a workpiece to be vacuum-processed and a workpiece having been vacuum-processed, and a maintenance method for the vacuum processing device.

### BACKGROUND ART

Conventional vacuum processing devices for use in deposition and etching of a semiconductor film, an insulating film, and a metal film for example generally include a load lock chamber and a vacuum processing chamber. After a substrate is loaded in the load lock chamber, the load lock chamber is evacuated and the substrate is preheated. The substrate heated in the load lock chamber is loaded in the vacuum processing chamber where deposition or etching of a film is performed on the substrate. In such a vacuum processing device, it is required to successively process substrates in the vacuum processing chamber and it is required to successively feed preheated substrates to the vacuum processing chamber in order to improve the production efficiency. To meet such requirements, a vacuum processing device further including an unload lock chamber to which substrates are unloaded from the vacuum processing chamber is used.

Japanese Patent Laying-Open No. 2001-239144 (Patent Document 1) discloses a vacuum processing device including a vacuum preheating chamber serving as both of a load lock chamber and an unload lock chamber. The vacuum processing device with this configuration has an advantage that the area occupied by the vacuum processing device can be reduced. The vacuum processing device disclosed in Japanese Patent Laying-Open No. 2001-239144 (Patent Document 1) also includes a vacuum preheating device for preheating a substrate, and a processing chamber for processing a substrate transported from the vacuum preheating device, and uses any substrate transport means among a plurality of substrate transport means in the vacuum preheating device to transport a substrate having been processed in the processing chamber. Accordingly, while a substrate is processed in the processing chamber, another substrate can be preheated in the vacuum preheating chamber and, while the processed substrate is removed from the processing chamber, the preheated substrate can be transferred into the processing chamber. In other words, an effect of improving the production efficiency by shortening the waiting time for preheating is achieved.

U.S. Patent No. 4,289,598 (Patent Document 2) also discloses a plasma processing device in which multiple pairs of a cathode electrode and an anode electrode are arranged.
Patent Document 1: Japanese Patent Laying-Open No. 2001-239144
Patent Document 2: U.S. Patent No. 4,289,598

### DISCLOSURE OF THE INVENTION

### PROBLEMS TO BE SOLVED BY THE INVENTION

In a vacuum processing chamber of the vacuum device disclosed in Japanese Patent Laying-Open No. 2001-239144 (Patent Document 1), however, a plurality of members for performing vacuum processing on a substrate are arranged, resulting in inferior ease of maintenance for the members located inside the vacuum processing chamber. In the case, for example, where the vacuum device disclosed in Japanese Patent Laying-Open No. 2001-239144 (Patent Document 1) is configured to include multiple pairs of a cathode electrode and an anode electrode like those disclosed in U.S. Patent No. 4,289,598 (Patent Document 2) that are arranged perpendicularly to the direction of the transportation, the ease of maintenance for the members located inside the vacuum processing chamber is still more inferior.

Ordinary vacuum processing devices have an opening door for opening the upper side or a lateral side of the vacuum processing chamber, and maintenance is conducted through the opening door. For a configuration in which a plurality of vacuum processing units each configured to include a pair of a cathode electrode and an anode electrode are arranged, for example, ease of maintenance is superior for members in the vacuum processing chamber that are disposed near the opening door, while ease of maintenance is inferior for members located deep inside the vacuum processing chamber (located further from the opening door). In particular, maintenance of a vacuum processing device adapted to large-sized substrates is highly difficult, because of a long distance from the opening door to members deep inside the vacuum processing device.

The present invention has been made to solve the above-described problem, and a chief object of the present invention is to improve ease of maintenance of the inside of a vacuum processing chamber of a vacuum processing device.

### MEANS FOR SOLVING THE PROBLEMS

According to an aspect of the present invention, a vacuum processing device for performing vacuum processing on a workpiece is provided. The vacuum processing device includes a first processing chamber for receiving the workpiece through a first opening and housing the workpiece. The first processing chamber includes a vacuum processing unit for supporting the workpiece and performing vacuum processing on the workpiece. The vacuum processing device further includes an evacuatable second processing chamber for housing a workpiece to be vacuum-processed and a workpiece having been vacuum-processed. The second processing chamber includes a loading unit for supporting the workpiece to be vacuum-processed, and an unloading unit for supporting the workpiece having been vacuum-processed. The vacuum processing device further includes a gate unit provided between the first opening and the second processing chamber in such a manner that the gate unit is attachable to and detachable from the first processing chamber. The gate unit blocks and allows communication between the first processing chamber and the second processing chamber connected via the gate unit. The vacuum processing device further includes a transport device for loading the workpiece to be vacuum-processed from the loading unit to the vacuum processing unit through the first opening and the gate unit, and unloading the workpiece having been vacuum-processed from the vacuum processing unit to the unloading unit through the first opening and the gate unit, and a movement mechanism for separating the first processing chamber and the second processing chamber from each other.

Preferably, the vacuum processing device further includes a base for supporting the movement mechanism and the second processing chamber. The movement mechanism includes a wheel attached to a lower portion of the first processing chamber, and a rail mounted on the base.

Preferably, the vacuum processing device further includes at least one another first processing chamber. The movement mechanism separates the other first processing chamber and the second processing chamber from each other. The vacuum processing device further includes a slide mechanism for sliding the other first processing chamber in a direction perpendicular to a direction in which the first processing chamber is moved by the movement mechanism.

Preferably, the first processing chamber includes a plurality of the vacuum processing units disposed in an arrangement direction perpendicular to a direction in which the workpiece is loaded into the first processing chamber. The second processing chamber includes a plurality of the loading units disposed in the arrangement direction, and a plurality of the unloading units disposed in the arrangement direction. An interval at which the plurality of loading units are arranged, an interval at which the plurality of unloading units are arranged, and an interval at which the plurality of vacuum processing units are arranged are substantially identical to each other.

Preferably, the first opening is formed at a place of connection to the gate unit and the first opening is sized larger than a cross section of the vacuum processing unit.

Preferably, the first processing chamber has a second opening formed in a wall opposite to the first opening. The first processing chamber further includes a door for closing and opening the second opening.

More preferably, the second opening is sized larger than a cross section of the vacuum processing unit.

According to another aspect of the present invention, a vacuum processing factory having the above vacuum processing device disposed in the vacuum processing factory is provided. The vacuum processing factory defines a vacuum processing area in which the first processing chamber and the second processing chamber connected via the gate unit are disposed, and a maintenance area in which the first processing chamber separated from the second processing chamber is disposed. The first processing chamber for which maintenance is to be performed is moved to the maintenance area by the movement mechanism, and the first processing chamber for which maintenance is completed is moved to the vacuum processing area by the movement mechanism.

According to still another aspect of the present invention, a maintenance method for a vacuum processing device performing vacuum processing on a workpiece is provided. The vacuum processing device includes a first processing chamber for receiving the workpiece through a first opening and housing the workpiece. The first processing chamber includes a vacuum processing unit for supporting the workpiece and performing vacuum processing on the workpiece. The vacuum processing device further includes an evacuatable second processing chamber for housing a workpiece to be vacuum-processed and a workpiece having been vacuum-processed. The second processing chamber includes a loading unit for supporting the workpiece to be vacuum-processed, and an unloading unit for supporting the workpiece having been vacuum-processed. The vacuum processing device further includes a gate unit provided between the first opening and the second processing chamber in such a manner that the gate unit is attachable to and detachable from the first processing chamber. The gate unit blocks and allows communication between the first processing chamber and the second processing chamber connected via the gate unit. The vacuum processing device further includes a transport device for loading the workpiece to be vacuum-processed from the loading unit to the vacuum processing unit through the first opening and the gate unit, and unloading the workpiece having been vacuum-processed from the vacuum processing unit to the unloading unit through the first opening and the gate unit, and a movement mechanism for separating the first processing chamber and the second processing chamber from each other. The maintenance method includes the steps of: separating the first processing chamber and the second processing chamber from each other by using the movement mechanism; performing maintenance of the first processing chamber; and connecting the first processing chamber and the second processing chamber via the gate unit by using the movement mechanism.

Preferably, the vacuum processing device further includes at least one another first processing chamber. The movement mechanism separates the other first processing chamber and the second processing chamber from each other. The vacuum processing device further includes a slide mechanism for sliding the other first processing chamber in a direction perpendicular to a direction in which the first processing chamber is moved by the movement mechanism. The maintenance method further includes the steps of: separating the other first processing chamber and the second processing chamber from each other by using the movement mechanism; sliding the other first processing chamber by using the slide mechanism; and performing maintenance of the other first processing chamber.

### EFFECTS OF THE INVENTION

The present invention can improve ease of maintenance of the inside of a vacuum processing chamber of a vacuum processing device.

### BRIEF DESCRIPTION OF THE DRAWINGS

Fig. 1 is a schematic side view showing a vacuum processing device according to an embodiment.
Fig. 2 is a functional block diagram showing a functional configuration of a vacuum processing device according to an embodiment.
Fig. 3 is a schematic cross-sectional plan view showing a vacuum processing device according to an embodiment.
Fig. 4A is a schematic side view showing a workpiece and a transport unit.
Fig. 4B is a schematic cross section along arrow-headed line IVB-IVB in Fig. 4A.
Fig. 5 is a schematic side view showing a state where a vacuum processing chamber is separated from a gate valve.
Fig. 6 is a schematic rear view seen in the direction of arrow VI in Fig. 5.
Fig. 7 is a schematic front view seen in the direction of arrow VII in Fig. 5.
Fig. 8 is a schematic rear view seen in the direction of arrow VIII in Fig. 5.
Fig. 9 is a flowchart illustrating a process procedure of a vacuum processing method in a vacuum processing device according to an embodiment.
Fig. 10 is a flowchart illustrating a process procedure of a placement step.
Fig. 11 is a flowchart illustrating a process procedure of a placement and removal step.
Fig. 12 is a flowchart illustrating a process procedure of a maintenance step.
Fig. 13 is a schematic plan view illustrating a modification of a vacuum processing device.

### DESCRIPTION OF THE REFERENCE SIGNS

1 vacuum processing chamber; 101 first processing chamber (vacuum processing chamber); 102 second processing chamber (preparatory vacuum chamber); 103 gate valve; 104, 104a-104e vacuum processing unit; 105 cathode electrode; 106 anode electrode; 107 workpiece; 107a workpiece surface to be processed; 108, 108a-108e loading unit; 111, 111a-111e heating device; 114a maintenance door; 114b placement and removal door; 119, 119a-119e unloading unit; 200 movement mechanism; 202 transport unit; 204 support unit; 210 slide mechanism; 223 wheel; 224, 224a-224d rail

### BEST MODES FOR CARRYING OUT THE INVENTION

Embodiments of the present invention will be hereinafter described based on the drawings. In the following description, like components are denoted by like reference characters and, where the components have like names or functions, a detailed description of the components will not be repeated.

### ENTIRE CONFIGURATION OF VACUUM PROCESSING DEVICE

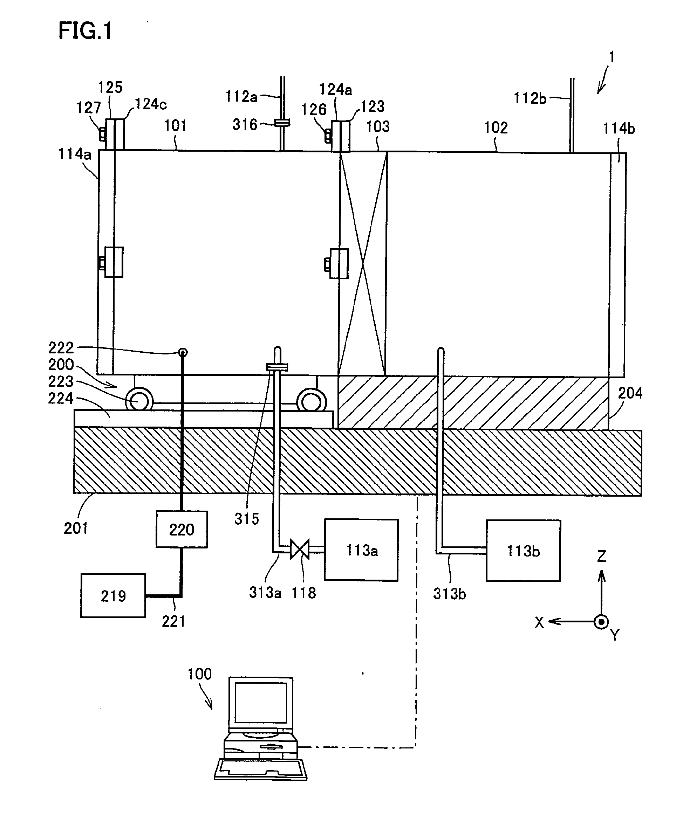

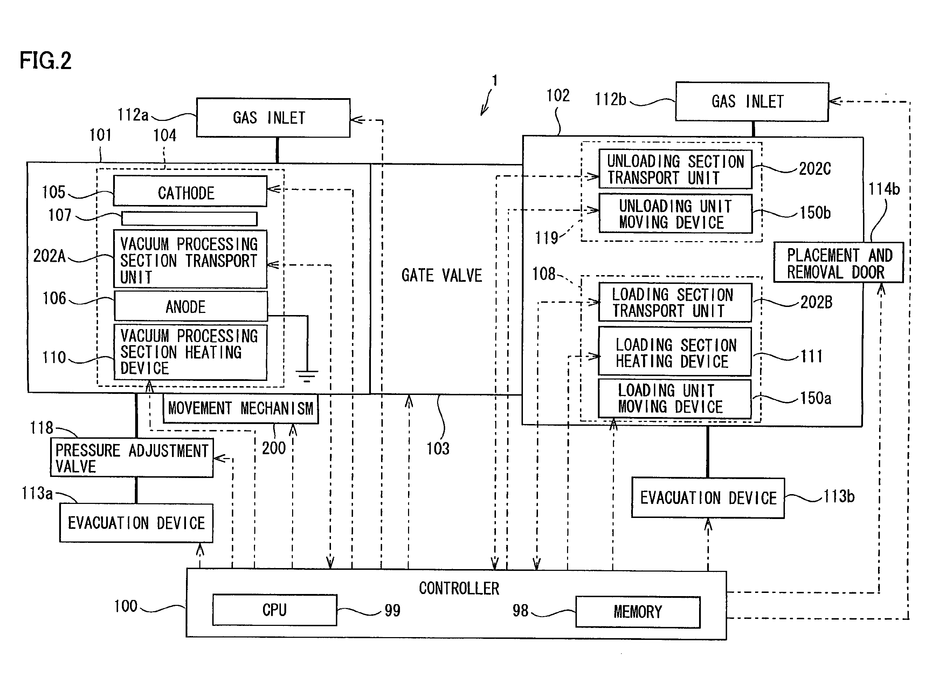

In the following, an entire configuration of a vacuum processing device 1 in the present embodiment will be described with reference to drawings. Fig. 1 is a schematic side view showing vacuum processing device 1 in the present embodiment. Fig. 2 is a functional block diagram showing a functional configuration of vacuum processing device 1 in the present embodiment.

First, vacuum processing device 1 will be described generally. As shown in Figs. 1 and 2, vacuum processing device 1 in the present embodiment includes a preparatory vacuum chamber 102 (second processing chamber) in which a workpiece 107 to be vacuum-processed is placed at a loading unit 108. While the inside of preparatory vacuum chamber 102 is decompressed, workpiece 107 is heated by a loading section heating device 111. When the air pressure in preparatory vacuum chamber 102 has reached a predetermined air pressure and the temperature of workpiece 107 has reached a predetermined temperature, a gate valve 103 is opened.

While gate valve 103 is opened, a workpiece 107 having been vacuum-processed is unloaded from a vacuum processing unit 104 in a vacuum processing chamber 101 (first processing chamber) to an unloading unit 119 in preparatory vacuum chamber 102. Then, workpiece 107 to be vacuum-processed is loaded from loading unit 108 in preparatory vacuum chamber 102 to vacuum processing unit 104 of vacuum processing chamber 101 (first processing chamber).

After gate valve 103 is closed, workpiece 107 is vacuum-processed at vacuum processing unit 104. While the workpiece is vacuum-processed, workpiece 107 having been vacuum-processed is removed to the outside, and a workpiece 107 to be vacuum-processed is placed at loading unit 108.

In vacuum processing device 1 of the present embodiment, after vacuum processing is conducted a predetermined number of times or for a predetermined period of time, a movement mechanism 200 separates vacuum processing chamber 101 and preparatory vacuum chamber 102 (gate valve 103) from each other. A maintenance service person for example of vacuum processing device 1 can easily perform maintenance of the inside of vacuum processing chamber 101 which is separated from preparatory vacuum chamber 102 (gate valve 103).

In the following, a configuration for implementing the above functions will be described in detail.

As shown in Figs. 1 and 2, vacuum processing device 1 includes vacuum processing chamber 101 in which vacuum processing is performed, gate valve 103, and evacuatable preparatory vacuum chamber 102 connected to vacuum processing chamber 101 via gate valve 103.

To vacuum processing chamber 101, an evacuation device 113a for evacuating vacuum processing chamber 101 is connected via an evacuation pipe 313a. Between evacuation device 113a and vacuum processing chamber 101, a pressure adjustment valve 118 is provided for keeping constant the pressure, in vacuum processing chamber 101, of a gas introduced from a gas inlet pipe 112a. At evacuation pipe 313a, a quick coupling 315 is provided so that evacuation pipe 313a is easily disconnected, at quick coupling 315, from vacuum processing chamber 101.

To preparatory vacuum chamber 102, an evacuation device 113b for evacuating preparatory vacuum chamber 102 is connected via an evacuation pipe 313b. As evacuation devices 113a, 113b, vacuum pumps for example are used.

For vacuum processing chamber 101, gas inlet pipe 112a is provided for introducing a gas to be used for vacuum processing such a plasma processing. At gas inlet pipe 112a, a quick coupling 316 is provided so that gas inlet pipe 112a is easily disconnected from vacuum processing chamber 101 by means of quick coupling 316.

Further, to vacuum processing chamber 101, a power supply 219 for supplying electric power to electrodes in vacuum processing chamber 101 is connected. Power supply 219 is connected by a power supply line 221 to vacuum processing chamber 101 via an impedance matching device 220. Vacuum processing chamber 101 and power supply line 221 are connected via an electrical connector 222 provided to an outer wall of vacuum processing chamber 101, so that power supply line 221 is easily disconnected from vacuum processing chamber 101.

A wall of vacuum processing chamber 101 that is opposite to gate valve 103 is provided with a maintenance door 114a for performing maintenance of the inside of vacuum processing chamber 101. Preferably, maintenance door 114a has a size equal to the entire wall, opposite to gate valve 103, of vacuum processing chamber 101, so that maintenance of the inside of vacuum processing chamber 101 is facilitated.

For preparatory vacuum chamber 102, a gas inlet pipe 112b is provided for gradually introducing a leak gas when the inside of preparatory vacuum chamber 102 is opened to the atmosphere.

A wall of preparatory vacuum chamber 102 that is opposite to gate valve 103 is provided with a placement and removal door 114b for placement of workpiece 107 in preparatory vacuum chamber 102 and removal of workpiece 107 from the inside of preparatory vacuum chamber 102. Preferably, placement and removal door 114b is configured to have a size that allows workpiece 107 to be transferred into and out of the chamber without the need to move loading unit 108 and unloading unit 119. More specifically, placement and removal door 114b is formed so that the height of the door is longer than the height of loading unit 108 and unloading unit 119 and the width of the door is longer than the width of loading unit 108 and unloading unit 119. In this case, a user having placed workpiece 107 at loading unit 108 can remove workpiece 107 from unloading unit 119 without moving loading unit 108 and unloading unit 119.

Preparatory vacuum chamber 102 is placed on a base 201 with a support 204 between the chamber and the base. Under vacuum processing chamber 101, movement mechanism 200 is provided. Movement mechanism 200 is disposed on base 201. More specifically, to the lower portion of vacuum processing chamber 101, a wheel 223 is rotatably attached. On base 201, a rail 224 is extended from preparatory vacuum chamber 102 toward vacuum processing chamber 101. Movement mechanism 200 includes wheel 223 and rail 224, and wheel 223 is placed on rail 224.

As seen from above, rotation of wheel 223 allows vacuum processing chamber 101 to come away from or closer to gate valve 103 and preparatory vacuum chamber 102. In the case for example where vacuum processing chamber 101 is large (heavy), it is preferable to increase the diameter of wheel 223, supply a lubricating oil onto the rail, or place an air jet device for floating vacuum processing chamber 101 by air.

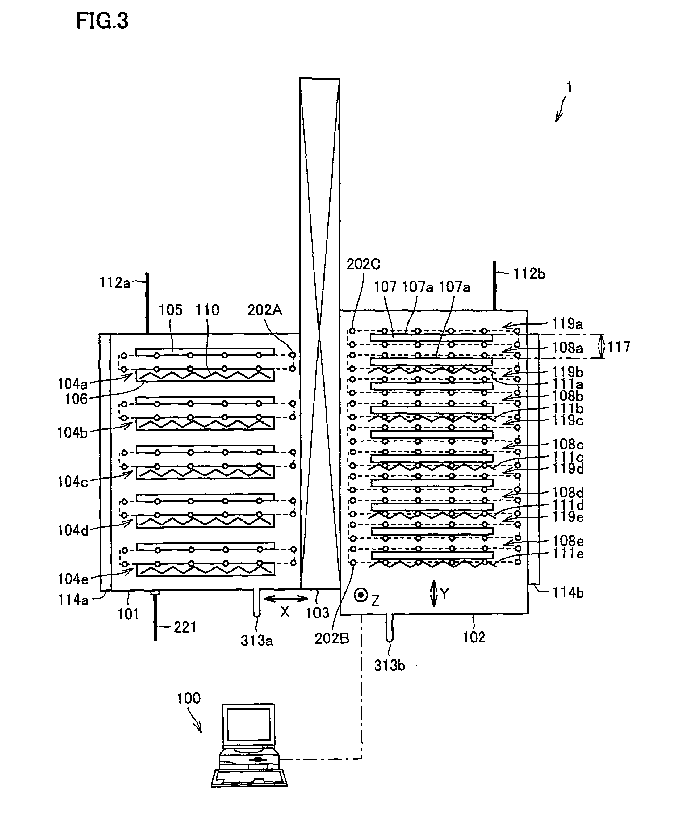

Fig. 3 is a schematic plan view showing the interior of vacuum processing device 1 in the present embodiment. As shown in Figs. 2 and 3, a plurality of vacuum processing units 104a to 104e are provided in vacuum processing chamber 101. In the following, vacuum processing units 104a to 104e will also be referred to collectively as vacuum processing unit 104. Each vacuum processing unit 104 has a pair of a cathode electrode 105 and an anode electrode 106 with a parallel flat electrode structure. Cathode electrode 105 is supplied with AC power from power supply 219 via an impedance matching device 220 and power supply line 221. Anode electrode 106 is grounded.

In vacuum processing chamber 101, a vacuum processing section heating device 110 for heating a workpiece 107 to be processed is placed on anode electrode 106 side of each vacuum processing unit 104. For vacuum processing section heating device 110, a lamp heater or a heater using heat generated from a resistor is generally used. It should be noted, however, it is not necessary that vacuum processing section heating device 110 is integrated with anode electrode 106, and may be placed separately from anode electrode 106. Workpiece 107 is placed so that workpiece 107 is located in parallel with and is electrically connected to anode electrode 106.

In the present embodiment, workpiece 107 in each vacuum processing unit 104 is plasma-processed (vacuum-processed) with a plasma generated between cathode electrode 105 and anode electrode 106. While the vacuum processing may be deposition by plasma CVD (Chemical Vapor Deposition) for example, the vacuum processing is not limited to this and may be deposition by sputtering or vapor deposition, or plasma etching, for example.

In preparatory vacuum chamber 102, a plurality of loading units 108a to 108e are provided. In the following, loading units 108a to 108e will also be referred to collectively as loading unit 108. At each loading unit 108, workpiece 107 before being vacuum-processed in vacuum processing chamber 101 is placed. Each loading unit 108 has heater (loading unit section heating device) 111 for preheating workpiece 107.

Heaters 111a to 111e provided at respective loading units 108a to 108e are arranged so that loading units 108a to 108e are substantially identical to each other in terms of the relative positional relation (distance) between heaters 111a to 111e each and workpiece 107 held at loading units 108a to 108e. Namely, the relative positional relation between workpiece 107 and heater 111a contained in loading unit 108a is substantially identical to respective relations in other loading units 108b to 108e.

In preparatory vacuum chamber 102, a plurality of unloading units 119a to 119e are also provided. In the following, unloading units 119a to 119e will also be referred to collectively as unloading unit 119. At each unloading unit 119, workpiece 107 having been vacuum-processed in vacuum processing chamber 101 is placed, and workpiece 107 having been vacuum-processed is removed from each unloading unit 119 to the outside of preparatory vacuum chamber 102.

Here, a plurality of loading units 108a to 108e are disposed so that the distance between workpieces 107 (workpiece surfaces 107a to be processed) held at loading units 108a to 108e respectively is substantially identical to the distance between workpieces 107 (workpiece surfaces 107a to be processed) held at a plurality of vacuum processing units 104a to 104e respectively. Likewise, a plurality of unloading units 119a to 119e are disposed so that the distance between workpieces 107 held at unloading units 119a to 119e respectively is substantially identical to the distance between workpieces 107 held at a plurality of vacuum processing units 104a to 104e respectively.

As shown in Fig. 3, in vacuum processing device 1 in the present embodiment, loading units 108a to 108e and unloading units 119a to 119e in preparatory vacuum chamber 102 are arranged alternately along movement direction Y in which they are moved. Specifically, loading units 108a to 108e and unloading units 119a to 119e are disposed along movement direction Y of loading units 108a to 108e and unloading units 119a to 119e in the order, from the right side (from the top in Fig. 3), of unloading unit 119a, loading unit 108a, unloading unit 119b, ... and loading unit 108e.

Loading units 108a to 108e and unloading units 119a to 119e are spaced by a predetermined distance along direction Y perpendicular to transport direction X in which workpiece 107 is transported, and are configured to be movable by a predetermined distance along direction Y (top-bottom direction as seen in Fig. 3) in which they are arranged.

In the present embodiment, the distance by which loading units 108a to 108e and unloading units 119a to 119e are moved is substantially identical to the distance between respective workpiece surfaces 107a of workpieces 107 held respectively at loading unit 108a and unloading unit 119a adjacent to each other. By way of example, loading units 108a to 108e and unloading units 119a to 119e are movable by a distance 117 which is the interval between workpiece surface 107a of workpiece 107 held at loading unit 108e and workpiece surface 107a of workpiece 107 held at unloading unit 119a.

More specifically, loading units 108a to 108e are each moved in the Y direction by a loading unit moving device 150a. Unloading units 119a to 119e are each moved in the Y direction by an unloading unit moving device 150b. Here, loading units 108a to 108e and unloading units 119a to 119e may be configured to move independently of each other in the Y direction or together in the Y direction. In order to simplify the device configuration of vacuum processing device 1 itself, it is preferable that loading unit moving device 150a and unloading unit moving device 150b move in cooperation with each other so that loading units 108a to 108e and unloading units 119a to 119e move together.

Specifically, loading unit 108 and unloading unit 119 may be supported by the same frame (not shown) and the frame may slide on rails (not shown) disposed in the Y direction.

Movement direction Y of loading unit 108 and unloading unit 119 is preferably orthogonal to transport direction X (left-right direction in Fig. 3) of workpiece 107. Movement direction Y may be the Y direction shown in Fig. 3, or the direction perpendicular to the plane of Fig. 3 (the direction perpendicular to both of transport direction X and movement direction Y, referred to as Z direction hereinafter). In other words, the direction of moving loading unit 108 and unloading unit 119 may be any as long as loading unit 108 and unloading unit 119 can move to respective positions where workpiece 107 is easily delivered to and received from a transport unit 202A of vacuum processing unit 104 as described later. Namely, it is preferable that loading unit 108 and unloading unit 119 are arranged in a direction including at least one of the Y direction component and the Z direction component so that loading unit 108 and unloading unit 119 can move in the direction.

In the present embodiment, Fig. 3 is a plan view and the Z direction is the vertical direction. Alternatively, Fig. 3 may be a side view and the Y direction may be the vertical direction.

Gate valve 103 provided between vacuum processing chamber 101 and preparatory vacuum chamber 102 can be opened and closed. Gate valve 103 is opened to allow the inside of vacuum processing chamber 101 and the inside of preparatory vacuum chamber 102 to communicate with each other. In the state where a vacuum is generated in preparatory vacuum chamber 102, gate valve 103 may be opened so that workpiece 107 can be transported between vacuum processing chamber 101 and preparatory vacuum chamber 102 while keeping the vacuum in vacuum processing chamber 101.

Vacuum processing chamber 101 and preparatory vacuum chamber 102 are provided with a transport unit 202. Transport unit 202 may be any as long as the transport unit can transport workpiece 107 from loading unit 108 to vacuum processing unit 104 and transport workpiece 107 from vacuum processing unit 104 to unloading unit 119. The transport unit may be provided at one or both of vacuum processing chamber 101 and preparatory vacuum chamber 102.

In vacuum processing device 1 of the present embodiment, loading unit 108 and unloading unit 119 are movable in the direction in which they are disposed side by side (arrangement direction Y) as described above, so that vacuum processing unit 104 and loading unit 108 can be aligned linearly in transport direction X of workpiece 107 and vacuum processing unit 104 and unloading unit 119 can be aligned linearly in transport direction X thereof. In other words, vacuum processing device 1 includes the movement device (loading unit moving device 150a and unloading unit moving device 150b) for moving loading unit 108 and unloading unit 119, and is therefore capable of linearly transporting workpiece 107 by means of transport unit 202, as described above.

As shown in Figs. 2 and 3, transport unit 202 in the present embodiment is configured to include a loading section transport unit 202B provided at loading unit 108 for holding workpiece 107 to be vacuum-processed, an unloading section transport unit 202C provided at unloading unit 119 for holding workpiece 107 having been vacuum-processed, and a vacuum processing section transport unit 202A provided at vacuum processing unit 104 for holding workpiece 107 which is vacuum-processed. Transport units 202A, 202B, and 202C have respective configurations substantially identical to each other, and therefore vacuum processing section transport unit 202A provided at vacuum processing unit 104 will be described below.

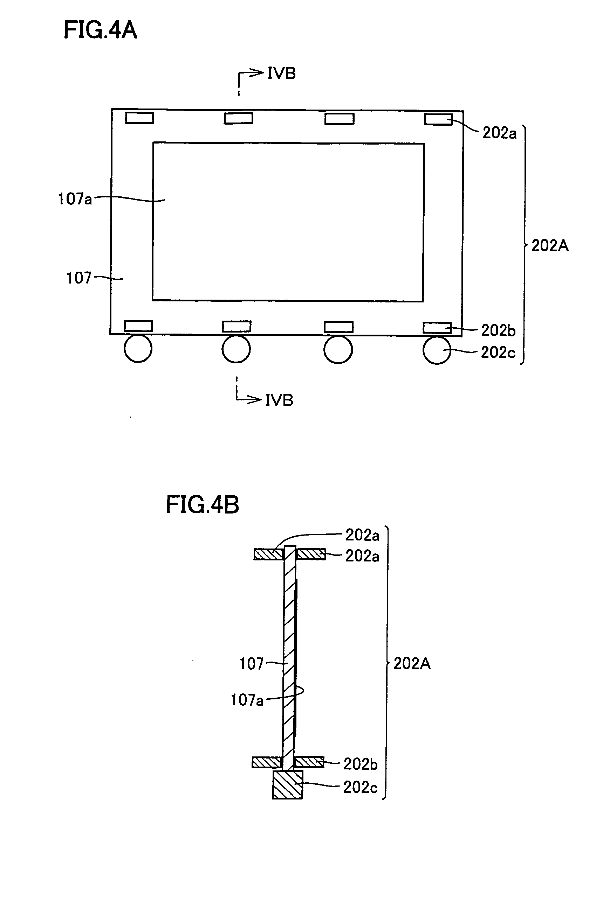

Fig. 4A is a side view of workpiece 107 and transport unit 202 as seen from surface 107a to be processed of workpiece 107, and Fig. 4B is a schematic cross section along arrow-headed line IVB-IVB in Fig 4A. As shown in Figs. 4A and 4B, workpiece 107 is mounted on drive rollers 202c having the rotational axis in the horizontal direction. The lateral sides of workpiece 107 are laterally supported by driven rollers 202a and driven rollers 202b. Drive rollers 202c are rotated by a motor or the like for moving workpiece 107 linearly in transport direction X.

With the above-described configuration, workpiece 107 to be vacuum-processed can be transported to vacuum processing unit 104 so that workpiece surface 107a can be vacuum-processed, and workpiece 107 having been vacuum-processed can be transported to unloading unit 119. Specifically, transport unit 202B of loading unit 108 and transport unit 202A of vacuum processing unit 104 transport workpiece 107 to be vacuum-processed from loading unit 108 to vacuum processing unit 104, and transport unit 202A of vacuum processing unit 104 and transport unit 202C of unloading unit 119 transport workpiece 107 having been vacuum-processed from vacuum processing unit 104 to unloading unit 119. In the case where workpiece 107 is to be linearly moved along transport direction X, a transport system of a simple configuration may be employed, using rollers 202a, 202b ..., guide, rail, and groove for example and applying thrust to workpiece 107 by means of a motor or the like as described above.

In the present embodiment, workpiece 107 is placed so that workpiece surface 107a to be processed is perpendicular to the horizontal plane. Workpiece 107, however, may be held at any angle as described above.

### MOVEMENT MECHANISM 200

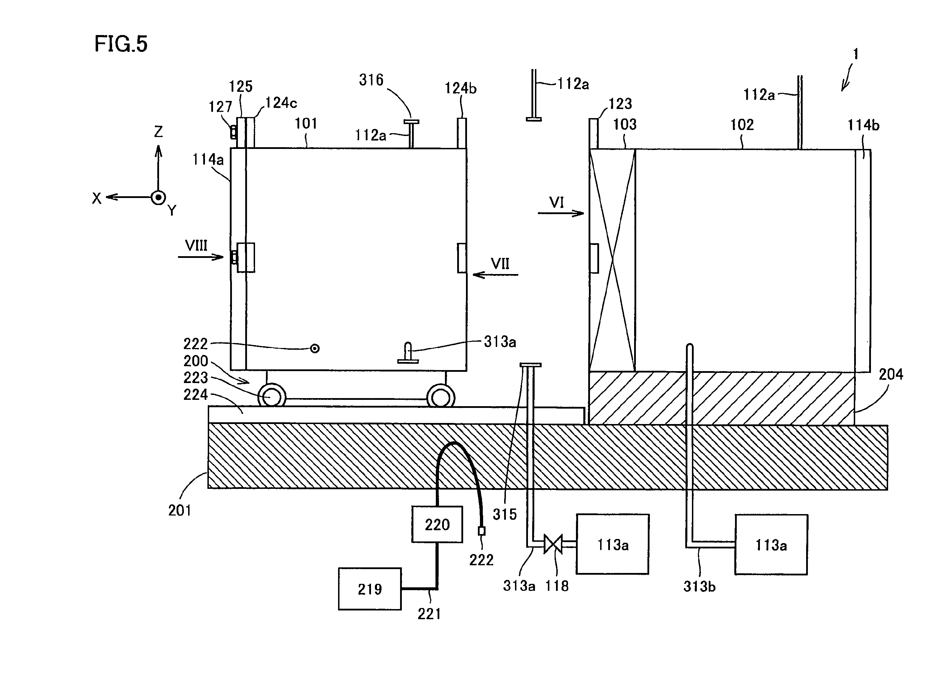

Next, a configuration of movement mechanism 200 for moving vacuum processing chamber 101 with respect to preparatory vacuum chamber 102 will be described. Fig. 5 is a schematic side view showing a state where vacuum processing chamber 101 is separated from gate valve 103. As shown in Fig. 5, quick coupling 315 is detached so as to detach evacuation pipe 313a from vacuum processing chamber 101. Quick coupling 316 is also detached so as to detach gas inlet pipe 112a from vacuum processing chamber 101. Power supply line 221 is detached from electrical connector 222 so as to detach power supply line 221 from vacuum processing chamber 101.

In the state where evacuation pipe 313a, gas inlet pipe 112a, and power supply line 221 are detached from vacuum processing chamber 101, wheels 223 attached to the lower portion of vacuum processing chamber 101 rotate on rail 224 to cause vacuum processing chamber 101 to come away from or closer to gate valve 103.

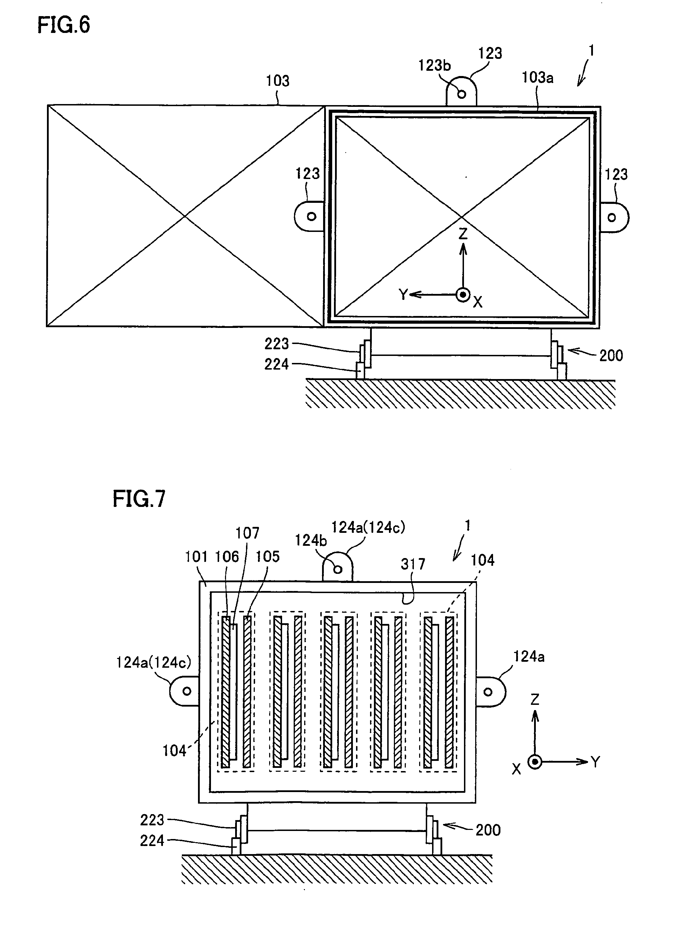

Fig. 6 is a schematic rear view seen in the direction of arrow VI in Fig. 5. Specifically, Fig. 6 is a schematic rear view showing gate valve 103 seen from vacuum processing chamber 101 while vacuum processing chamber 101 is separated from gate valve 103. As shown in Fig. 6, in order to ensure air-tightness between gate valve 103 and vacuum processing chamber 101, an O-ring 103a for creating a vacuum seal is provided along the periphery of gate valve 103. For example, O-ring 103a is fit in a croze (packing groove) formed along the periphery of gate valve 103. O-ring 103 a has a portion protruding from the croze, and this portion is deformed by a pressure exerted when vacuum processing chamber 101 is connected to gate valve 103, and accordingly brought into close contact with the periphery of vacuum processing chamber 101. In this way, a seal is created between vacuum processing chamber 101 and gate valve 103.

As shown in Figs. 1, 5, and 6, a rib 123 is formed at the periphery of the rear end of gate valve 103. Rib 123 has a bolt hole 123b formed therein.

Fig. 7 is a schematic front view seen in the direction of arrow VII in Fig. 5. Namely, Fig. 7 is a schematic front view showing vacuum processing chamber 101 as seen from gate valve 103, while gate valve 103 is separated from vacuum processing chamber 101. Vacuum processing chamber 101 has a side to be connected to gate valve 103, and this side has a first opening 317 formed therein. In order to ensure good ease of maintenance of the inside of vacuum processing chamber 101 when vacuum processing chamber 101 is separated from gate valve 103, preferably the size of first opening 317 is larger than the size of vacuum processing units 104a to 104e as seen from the front side. In other words, first opening 317 is formed so that vacuum processing units 104a to 104e arranged in vacuum processing chamber 101 are located within first opening 317 as seen from the front side.

As shown in Figs. 1, 5 and 7, a rib 124a is formed at the periphery of the front end of vacuum processing chamber 101. Rib 124a has a bolt hole 124b is formed therein.

Thus, as shown in Figs. 1, 6, and 7, in the state where vacuum processing chamber 101 is in contact with gate valve 103, rib 123 of the rear end of gate valve 103 and rib 124a of the front end of vacuum processing chamber 101 are fastened by a fastening bolt 126 so as to allow vacuum processing chamber 101 to be pressed against gate valve 103 and thereby secured. On the contrary, as shown in Figs. 5, 6, and 7, fastening bolt 126 may be removed from rib 123 of the rear end of gate valve 103 and from rib 124a of the front end of vacuum processing chamber 101 to release the coupling between vacuum processing chamber 101 and gate valve 103 and thereby separate vacuum processing chamber 101 from gate valve 103 via movement mechanism 200.

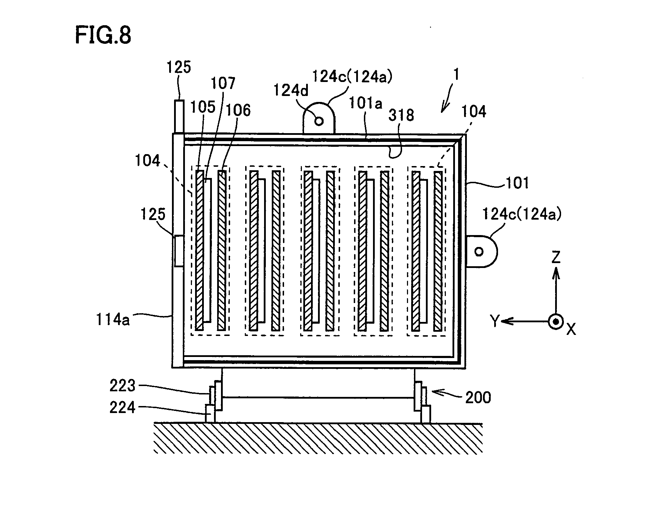

Fig. 8 is a schematic rear view as seen in the direction of arrow VIII in Fig. 5. Namely, Fig. 8 is a schematic rear view showing vacuum processing chamber 101 from the side located opposite to gate valve 103, while maintenance door 114a is opened. As shown in Fig. 8, vacuum processing chamber 101 has a second opening 318 formed in such a manner that the opening can be opened and closed by maintenance door 114a. Like first opening 317, the size of second opening 318 is preferably larger for maintenance. In the present embodiment, second opening 318 is formed so that the whole rear side in vacuum processing chamber is opened by opening maintenance door 114a.

In order to ensure good ease of maintenance of the inside of vacuum processing chamber 101 when maintenance door 114a is opened, preferably the size of second opening 318 is larger than the size of vacuum processing units 104a to 104e as seen from the rear side. Namely, second opening 318 is formed so that vacuum processing units 104a to 104e arranged in vacuum processing chamber 101 are located within second opening 318 as seen from the rear side.

Along the periphery of second opening 318 of the rear side of vacuum processing chamber 101, a croze is formed similarly to the croze along the periphery of gate valve 103, and an O-ring 101a is fit in the croze. When maintenance door 114a is closed, O-ring 101a creates a seal between maintenance door 114a and the periphery of the rear side of vacuum processing chamber 101, so that the vacuum in vacuum processing chamber 101 can be maintained.

Specifically, maintenance door 114a is connected to vacuum processing chamber 101 in such a manner that enables the maintenance door to turn on the left side of the door. At the periphery of the rear end of vacuum processing chamber 101, a rib 124c is formed. Rib 124c has a bolt hole 124d formed therein. At the periphery of maintenance door 114a, a rib 125 is formed. Rib 125 has a bolt hole (not shown) formed therein.

As shown in Figs. 1, 5, and 8, maintenance door 114a is turned to be brought into close contact with O-ring 101a, while rib 125 of maintenance door 114a and rib 124c of vacuum processing chamber 101 are fastened with a fastening bolt 127 so as to hermetically close the rear section of vacuum processing chamber 101. On the contrary, fastening bolt 127 is removed to release the fastening between rib 125 of maintenance door 114a and rib 124c of vacuum processing chamber 101. Maintenance door 114a is then turned to open the rear section of vacuum processing chamber 101.

As described above, vacuum processing chamber 101 can be moved to be separated from gate valve 103 to facilitate maintenance of the inside of vacuum processing chamber 101. Namely, first opening 317 of vacuum processing chamber 101 is formed to allow a user of vacuum processing device 1 to have a space necessary for cleaning the inside of vacuum processing chamber 101 without being hindered by a structure such as an electrode in vacuum processing chamber 101, and easily replace, from the front side of vacuum processing chamber 101, any part in vacuum processing chamber 101.

Maintenance door 114a can be opened to open the rear side of vacuum processing chamber 101. Therefore, a user of vacuum processing chamber 101 can also access, from the rear side of vacuum processing chamber 101, the inside of vacuum processing chamber 101. The workability of maintenance of the inside of vacuum processing chamber 101 is accordingly improved. Namely, for vacuum processing device 1 in the present embodiment, a maintenance service person for example can conduct maintenance of the inside of vacuum processing chamber 101, from both of the front side (first opening 317) and the rear side (second opening 318) of vacuum processing chamber 101, and thus easily conduct maintenance of both of the front section and the rear section in vacuum processing chamber 101.

It should be noted that movement mechanism 200 may be provided to preparatory vacuum chamber 102 and gate valve 103. Specifically, vacuum processing chamber 101 is mounted on support 204 and a wheel 203 is pivotably supported below preparatory vacuum chamber 102. In this case, a rail 224 is extended on preparatory vacuum chamber 102. When maintenance of the inside of vacuum processing chamber 101 is to be performed, preparatory vacuum chamber 102 is moved in the direction of separating preparatory vacuum chamber 102 from vacuum processing chamber 101.

### VACUUM PROCESSING IN VACUUM PROCESSING DEVICE

An embodiment of a vacuum processing method using vacuum processing device 1 of the present embodiment will be described hereinafter with reference to drawings. As shown in Fig. 2, the constituent devices of vacuum processing device 1 are each connected via a cable or interface to a controller 100, and the following steps are mainly carried out through operation of controller 100. Specifically, controller 100 includes therein a memory 98 in which a program for controlling vacuum processing device 1 is stored, and a CPU 99 reading the program for controlling vacuum processing device 1. In the present embodiment, the vacuum processing performed by vacuum processing device 1 is controlled by software executed on controller 100.

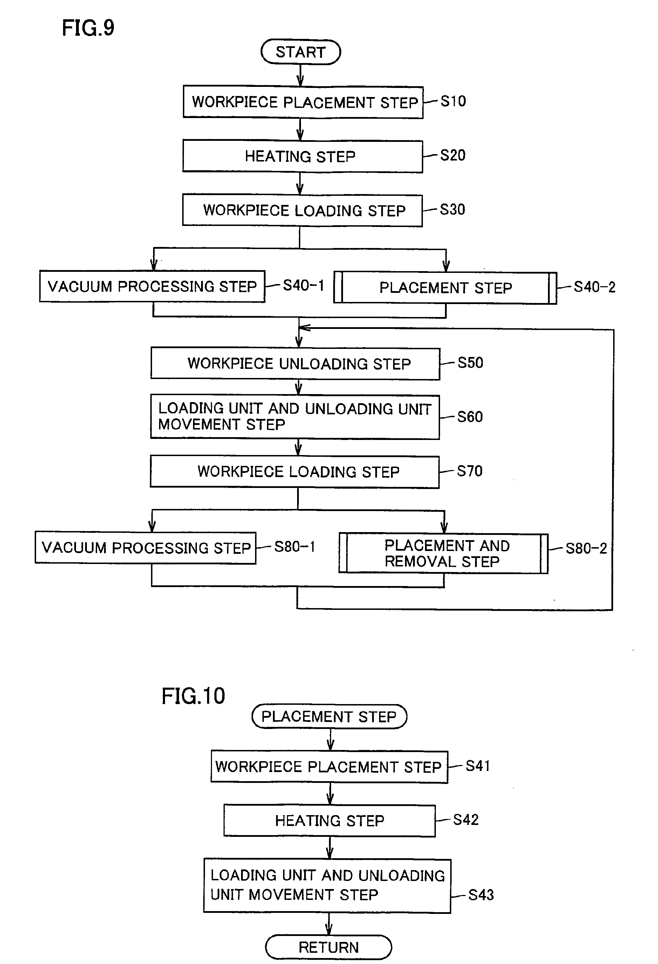

Fig. 9 is a flowchart illustrating a process procedure of a vacuum processing method in vacuum processing device 1 of the present embodiment.

### WORKPIECE PLACEMENT STEP:

As shown in Fig. 9, controller 100 first causes a leak by opening gas inlet pipe 112b to introduce nitrogen gas into preparatory vacuum chamber 102. When the inside of preparatory vacuum chamber 102 reaches the atmospheric pressure, placement and removal door 114b is opened so as to open the inside of preparatory vacuum chamber 102 to the atmosphere. In this state, workpiece 107 to be vacuum-processed is disposed at loading unit 108. After workpiece 107 is disposed at loading unit 108, placement and removal door 114b is hermetically closed (step 10, step is hereinafter abbreviated as S).

### HEATING STEP:

Next, evacuation device 113b is activated to evacuate preparatory vacuum chamber 102. At the same time, heater 111 is turned on to heat workpiece 107 (S20).

### WORKPIECE LOADING STEP:

After the temperature of workpiece 107 reaches a predetermined temperature and the degree of vacuum of the inside of preparatory vacuum chamber 102 reaches a predetermined degree of vacuum, gate valve 103 for allowing and blocking communication between vacuum processing chamber 101 and preparatory vacuum chamber 102 is opened. While the vacuum of respective insides of vacuum processing chamber 101 and preparatory vacuum chamber 102 is maintained, transport unit 202 loads workpiece 107 to be vacuum-processed from loading unit 108 in preparatory vacuum chamber 102 to vacuum processing unit 104 in vacuum processing chamber 101 (S30). After workpiece 107 is loaded in vacuum processing unit 104, heater 111 is turned off and gate valve 103 is closed. As for the timing at which loading unit 108 is moved to a predetermined position for transporting the workpiece (the position where loading unit 108 and vacuum processing unit 104 are linearly aligned), the timing may be before, after or while gate valve 103 is opened.

### VACUUM PROCESSING STEP:

Controller 100 causes a voltage to be applied to the cathode side to deposit a silicon film for example by plasma CVD or the like on workpiece 107 loaded in vacuum processing unit 104 (S40-1). While vacuum processing device 1 is operating, vacuum processing section heating device 110 in vacuum processing chamber 101 is kept supplied with electric power, and the output of the heating device is controlled by controller 100 so that the temperature of workpiece 107 is kept for example at 170°C.

Specifically, after gate valve 103 is closed, a reaction gas constituted of hydrogen gas and silane gas is introduced from gas inlet pipe 112a into vacuum processing chamber 101. Pressure adjustment valve 118 is used to adjust the pressure in vacuum processing chamber 101 to a predetermined pressure. Then, high-frequency power (frequency of 13.56 MHz for example) is fed to cathode electrode 105 to generate a plasma between cathode electrode 105 and anode electrode 106. The plasma decomposes the reaction gas and accordingly the silicon film is formed on workpiece 107. After the silicon film of a predetermined thickness is formed, controller 100 causes power feeding to cathode electrode 105 to be stopped. Controller 100 also causes introduction of the reaction gas to be stopped so as to evacuate vacuum processing chamber 101.

### PLACEMENT STEP

Fig. 10 is a flowchart illustrating a process procedure of a placement step (S40-2). As illustrated in Figs. 9 and 10, a workpiece placement step (S41), a heating step (S42), and a loading unit and unloading unit movement step (S43) (these steps are collectively referred to as placement step S40-2) are executed in parallel with execution of the vacuum processing step (S40-1).

### WORKPIECE PLACEMENT STEP:

In preparatory vacuum chamber 102, after the temperature of unloading unit 119 decreases to a predetermined temperature, controller 100 causes a leak by introducing nitrogen gas from gas inlet pipe 112b into preparatory vacuum chamber 102. After the inside of preparatory vacuum chamber 102 reaches the atmospheric pressure, placement and removal door 114b is opened so as to open the inside of preparatory vacuum chamber 102 to the atmosphere. After workpiece 107 to be vacuum-processed is disposed at loading unit 108, placement and removal door 114b is hermetically closed (S41).

### HEATING STEP:

Next, controller 100 causes evacuation device 113b to be activated so as to start evacuating preparatory vacuum chamber 102. Then, controller 100 causes heater 111 to be turned on so that workpiece 107 to be vacuum-processed is heated (S42).

### LOADING UNIT AND UNLOADING UNIT MOVEMENT STEP:

Next, in order to allow workpiece 107 having been vacuum-processed to be transported linearly along transport direction X from vacuum processing unit 104 to unloading unit 119, loading unit 108 and unloading unit 119 move in direction Y perpendicular to the direction in which workpiece 107 is transported (S43). Namely, respective positions of vacuum processing unit 104 and unloading unit 119 relative to each other are adjusted so that vacuum processing unit 104 and unloading unit 119 are aligned on an axis in transport direction X. It should be noted that this step may be performed at any time after the workpiece placement step (S41), and may be performed while workpiece 107 is heated by heater 111.

### WORKPIECE UNLOADING STEP:

After the temperature of workpiece 107 to be vacuum-processed in preparatory vacuum chamber 102 reaches a predetermined temperature, the degree of vacuum of the inside of preparatory vacuum chamber 102 reaches a predetermined degree of vacuum, the vacuum processing step in vacuum processing chamber 101 is completed, and the pressure in vacuum processing chamber 101 reaches a desired pressure, gate valve 103 allowing communication between vacuum processing chamber 101 and preparatory vacuum chamber 102 is opened. Next, transport unit 202C and transport unit 202B transport vacuum-processed workpiece 107 linearly from vacuum processing unit 104 to unloading unit 119 (S50).

### LOADING UNIT AND UNLOADING UNIT MOVEMENT STEP:

Next, in order to move workpiece 107 to be vacuum-processed that is housed in loading unit 108 linearly to vacuum processing unit 104 by transport unit 202A, namely in order to align loading unit 108 and vacuum processing unit 104 on an axis, loading unit 108 and unloading unit 119 move in direction Y perpendicular to transport direction X of workpiece 107 (S60).

### WORKPIECE LOADING STEP:

Next, vacuum processing section transport unit 202A and loading section transport unit 202B linearly load workpiece 107 to be vacuum-processed, from loading unit 108 to vacuum processing unit 104 (S70). After workpiece 107 to be vacuum-processed is loaded into vacuum processing unit 104, gate valve 103 is hermetically closed, and heater 111 is turned off.

### VACUUM PROCESSING STEP:

In a similar manner to the above-described one, a silicon film is deposited by plasma CVD on workpiece 107 to be vacuum-processed that has been loaded in vacuum processing unit 104 (S80-1). In this step, the same processing as that of the above-described vacuum processing step (S40-1) is carried out.

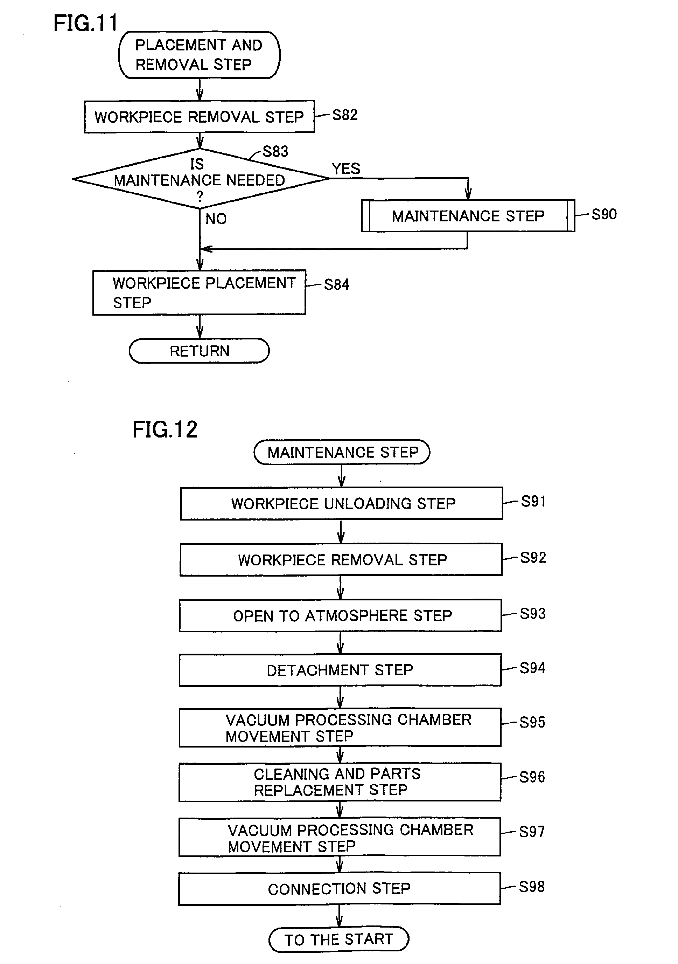

Fig. 11 is a flowchart illustrating a process procedure of a placement and removal step. As shown in Figs. 9 and 11, while the vacuum processing step (S80-1) is performed, a workpiece removal step (S82), a determination step (S83), and a workpiece placement step (S84), as well as a maintenance step depending on the case as described below (these steps are collectively referred to as placement and removal step S80-2) are performed in parallel with the vacuum processing step.

### WORKPIECE REMOVAL STEP:

When the temperature of vacuum-processed workpiece 107 with the silicon film formed thereon decreases to a predetermined temperature, gas inlet pipe 112b allows nitrogen gas to be introduced into preparatory vacuum chamber 102 for causing a leak. When the inside of preparatory vacuum chamber 102 becomes substantially identical to the atmospheric pressure, placement and removal door 114b is opened so as to open preparatory vacuum chamber 102 to the atmosphere, and vacuum-processed workpiece 107 is removed from unloading unit 119 (S82).

### DETERMINATION STEP:

After the workpiece removal step (S82), CPU 99 of controller 100 determines whether maintenance should be performed, based on a management item such as the number of times vacuum processing is performed, which is stored in memory 98 (S83). Specifically, each time a vacuum processing step (S40-1, S80-1) is completed, CPU 99 updates the number of times vacuum processing is performed which is stored in memory 98. Each time the workpiece removal step (S82) is completed or during the workpiece removal step (S82), CPU 100 determines whether the number of times vacuum processing is performed has exceeded a set number stored in advance in memory 98 (S83).

When it is determined that maintenance is necessary (YES in S83), a maintenance step (S90) as described below is performed. When it is determined that maintenance is not necessary (NO in S83), a workpiece placement step (S84) is performed in an ordinary manner.

### MAINTENANCE STEP:

Fig. 12 is a flowchart illustrating a process procedure of a maintenance step (S90). As illustrated in Fig. 12, when it is determined that maintenance is necessary (YES in S83), a workpiece unloading step (S91) and a workpiece removal step (S92) are performed after completion of the workpiece removal step (S82). In the workpiece unloading step (S91), a process similar to the above-described workpiece unloading step (S50) is performed. In the workpiece removal step (S92), a process similar to the above-described workpiece removal step (S82) is performed.

### OPEN TO ATMOSPHERE STEP:

After the workpiece removal step (S92), heater 110 is turned off. When the temperature of vacuum processing unit 104 has decreased to a predetermined temperature, nitrogen gas is introduced from gas inlet pipe 112a into vacuum processing chamber 101 to cause a leak (S93). Specifically, after a residual gas in vacuum processing chamber 101 is sufficiently purged, vacuum processing chamber 101 is opened to the atmosphere.

### DETACHMENT STEP:

Evacuation pipe 313a and gas inlet pipe 112a of vacuum processing chamber 101 are detached from vacuum processing chamber 101 by detachment of quick couplings 315 and 316. Power supply line 221 is also detached from vacuum processing chamber 101 by detachment of electrical connector 222. Further, a signal line and a power supply line for controlling each component of vacuum processing chamber 101 are also detached from electrical connector 222. Then, fastening bolt 126 that fastens vacuum processing chamber 101 and gate valve 103 is removed so as to release coupling between vacuum processing chamber 101 and gate valve 103 (S94).

### VACUUM PROCESSING CHAMBER MOVEMENT STEP:

Wheels 223 attached to the lower part of vacuum processing chamber 101 rotate on rail 224 to cause vacuum processing chamber 101 to move away from gate valve 103 (S95). At this time, in order to reduce motive power necessary for this movement, a system for applying a buoyant force to vacuum processing chamber 101 by a gas pressure or the like may be used together.

### CLEANING AND PARTS REPLACEMENT STEP:

After vacuum processing chamber 101 is separated from gate valve 103, fastening bolt 127 that fastens the rear part of vacuum processing chamber 101 and maintenance door 114a provided on the opposite side to gate valve 103 is removed, and maintenance door 114a is opened. Then, the inside of vacuum processing chamber 101 is cleaned and parts in the chamber are replaced, for example (S96). Thus, a user of vacuum processing device 1 can access the inside of vacuum processing chamber 101 from first opening 317 of vacuum processing chamber 101 that is located on gate valve 103 side as well as from second opening 318 thereof that is located opposite to gate valve 103, and can easily perform maintenance work such as cleaning of the inside of vacuum processing chamber 101 and replacement of parts, for example.

### VACUUM PROCESSING CHAMBER MOVEMENT STEP:

After the maintenance work is completed, fastening bolt 127 is used to fasten maintenance door 114a and vacuum processing chamber 101 to each other. Wheels 223 attached to the lower portion of vacuum processing chamber 101 are rotated on rail 224 to cause vacuum processing chamber 101 to contact gate valve 103 (S97).

### CONNECTION STEP:

After vacuum processing chamber 101 is brought into contact with gate valve 103, fastening bolt 126 is used to fasten vacuum processing chamber 101 and gate valve 103 to each other. Evacuation device 113 a is used to evacuate vacuum processing chamber 101. The degree of increase of the exhaust pressure is checked, and/or leakage of air into vacuum processing chamber 101 may be checked by means of helium leak test (S98).

### WORKPIECE PLACEMENT STEP:

After the workpiece placement step (S84) or maintenance step (S90), workpiece 107 to be vacuum-processed is placed at loading unit 108 and placement and removal door 114b is hermetically closed (S84).

After this, as shown in Fig. 9, controller 100 causes evacuation of preparatory vacuum chamber 102 to be started, heater 111 to be turned on, and workpiece 107 to be vacuum-processed to be heated at loading unit 108 (S20) Then, the workpiece loading step (S30), the vacuum processing step (S40-1), and the placement step (S40-2) are carried out. After this, as shown in Figs. 9 to 12, controller 100 causes the process from the workpiece loading step (S50) to the vacuum processing step (S80-1) and the placement and removal step (S80-2) to be repeated.

The series of steps is performed, so that workpieces 107 that are vacuum-processed at vacuum processing unit 104 can be efficiently replaced. While the vacuum processing step is performed, workpiece 107 having been vacuum-processed can be cooled and workpiece 107 to be vacuum-processed next can be heated. Thus, the takt time of vacuum processing device 1 (the process time necessary for one workpiece 107) can be shortened. In addition, even when a plurality of components such as cathode electrode 105 and anode electrode 106 are arranged in vacuum processing chamber 101, a maintenance service person for example can easily perform maintenance of the inside of vacuum processing chamber 101.

### MODIFICATION OF VACUUM PROCESSING DEVICE 1

A vacuum processing device 1b may include a plurality of vacuum processing chambers 101a, 101b. In this case, preferably vacuum processing chamber 101a detached from gate valve 103 is replaced with another vacuum processing chamber 101b for which maintenance has been completed. In this way, the time for maintenance can be shortened and the time for which vacuum processing device 1 is stopped can be shortened.

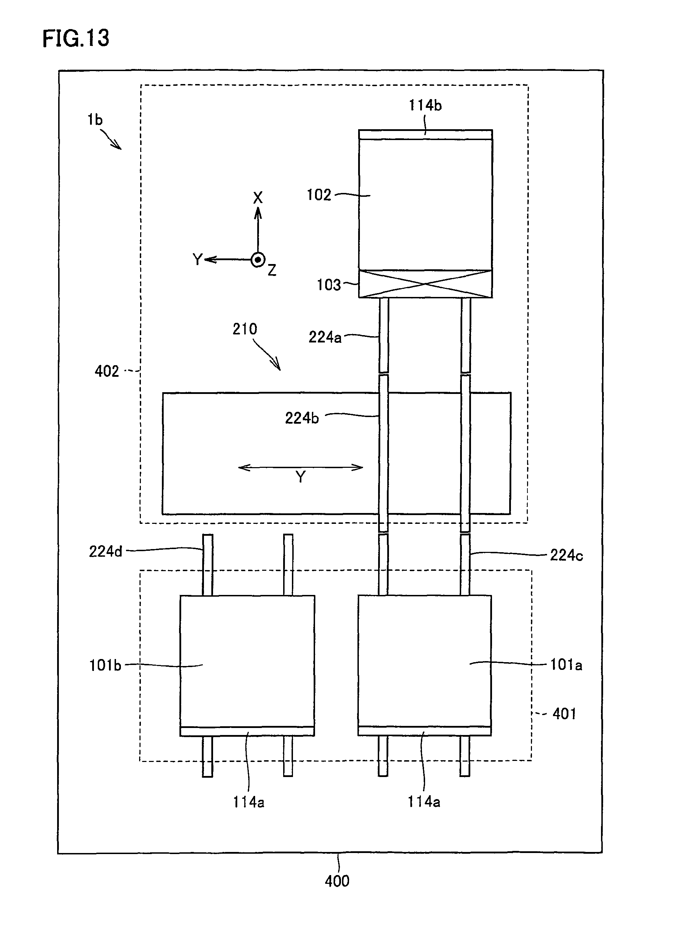

Fig. 13 is a schematic plan view showing a modification of vacuum processing device 1b. As shown in Fig. 13, vacuum processing device 1b includes a plurality of vacuum processing chambers 101a, 101b, and a slide mechanism 210. Rail 224 includes a first rail 224a fixed to base 201, a second rail 224b provided in such a manner that the second rail is slidable in the direction perpendicular to the direction along which rail 224a is disposed, and a third rail 224c (224d) fixed to base 201.

Third rails 224c, 224d are provided at base 201 for vacuum processing chambers 101a, 101b respectively. Namely, movement mechanism 200 includes a wheel 203 pivotably supported on the lower part of first vacuum processing chamber 101a, a wheel 203 pivotably supported on the lower part of second vacuum processing chamber 101b, first rail 224a disposed on base 201, second rail 224b mounted on slide mechanism 210 and caused to slide by slide mechanism 210, third rail 224c on which first vacuum processing chamber 101a is to be mounted, and third rail 224d ton which second vacuum processing chamber 101b is to be mounted.

By means of slide mechanism 210, second rail 224b is slidable from the position located on respective axes of first rail 224a and third rail 224c and between first rail 224a and third rail 224c, to the position located on the axis of third rail 224d. More specifically, second rail 224b may be mounted on slide mechanism 210 and slide mechanism 210 may be caused to slide by means of a motor or the like (not shown) or may be manually caused to slide.

Alternatively, vacuum processing device 1b may be configured without second rail 224b and third rails 224c and 224d may be caused to slide by slide mechanism 210.

In this way, vacuum processing chamber 101a which needs maintenance can be detached from gate valve 103, and moved from a vacuum processing area 402 to a maintenance area 401 via first rail 224a, second rail 224b, slide mechanism 210, and third rail 224c.

Then, another vacuum processing chamber 101b for which maintenance has been completed can also be moved from maintenance area 401 via third rail 224d, second rail 224b, slide mechanism 210, and first rail 224a to gate valve 103 (vacuum processing area 402) so as to be connected to gate valve 103. More specifically, vacuum processing chamber 101b is moved via third rail 224d and second rail 224b onto slide mechanism 210, and slide mechanism 210 is slid so that second rail 224b and first rail 224a are aligned on a line. Then, vacuum processing chamber 101b is coupled via second rail 224b and first rail 224a to gate valve 103.

### VACUUM PROCESSING CHAMBER REPLACEMENT STEP IN VACUUM PROCESSING

A process procedure of vacuum processing in vacuum processing device 1b in the present modification is similar to the procedure illustrated in Figs. 9 to 12, except for the procedure of the maintenance step (S90). In the case where vacuum processing device 1b includes a plurality of vacuum processing chambers 101a, 101b, a vacuum processing chamber replacement step may be executed instead of the cleaning and parts replacement step (S96) in the maintenance step (S90) illustrated in Fig. 12. Namely, in the vacuum processing chamber movement step (S95, S97), vacuum processing chamber 101a may be separated and moved from gate valve 103 while another vacuum processing chamber 101b for which maintenance has been completed in advance may be coupled to gate valve 103.

In this way, after vacuum processing chamber 101b is coupled to gate valve 103 and vacuum processing device 1 resumes vacuum processing, vacuum processing chamber 101 can undergo maintenance, which can shorten the time for which vacuum processing is stopped for maintenance.

As shown in Fig. 13, vacuum processing device 1b may be disposed and used in a vacuum processing factory 400. In vacuum processing factory 400, vacuum processing area 402 where vacuum processing chamber 101 and preparatory vacuum chamber 102 connected via gate valve 103 are disposed, and maintenance area 401 where vacuum processing chamber 101 separated from preparatory vacuum chamber 102 is disposed are defined (the factory is partitioned into these areas). Preferably, a fence or glass sheet for preventing entrance of working persons is erected around vacuum processing area 402, maintenance area 401, and a standby area. When maintenance is performed, vacuum processing chamber 101 is moved by movement mechanism 200 to maintenance area 401 and, when the maintenance has been completed, vacuum processing chamber 101 is moved by movement mechanism 200 to vacuum processing area 402.

As described above, in the case where preparatory vacuum chamber 102 is configured to be moved by movement mechanism 200 in vacuum processing device 1b, vacuum processing area 402 in which vacuum processing chamber 101 and preparatory vacuum chamber 102 connected via gate valve 103 are disposed, and a standby area (not shown) in which preparatory vacuum chamber 102 separated from vacuum processing chamber 101 is disposed are defined. When maintenance is performed on vacuum processing chamber 101 or preparatory vacuum chamber 102, preparatory vacuum chamber 102 is moved by movement mechanism 200 to the standby area and, when the maintenance has been completed, preparatory vacuum chamber 102 is moved by movement mechanism 200 to vacuum processing area 402.

According to the above description of Fig. 13, vacuum processing device 1b is disposed in vacuum processing factory 400. Above-described vacuum processing device 1 is also disposed in vacuum processing factory 400. Namely, in the case where vacuum processing device 1 is disposed in vacuum processing factory 400, above-described maintenance are 401, vacuum processing area 402, and the standby area are also disposed in vacuum processing factory 400.

It should be construed that embodiments disclosed herein are by way of illustration in all respects, not by way of limitation. It is intended that the scope of the present invention is defined by claims, not by the above description of the embodiments, and includes all modifications and variations equivalent in meaning and scope to the claims.

## Claims

1. A vacuum processing device (1) for performing vacuum processing on a workpiece (107), comprising:
a first processing chamber (101) for receiving said workpiece through a first opening (317) and housing said workpiece,
said first processing chamber including a vacuum processing unit (104) for supporting said workpiece and performing vacuum processing on said workpiece;
an evacuatable second processing chamber (102) for housing a workpiece to be vacuum-processed and a workpiece having been vacuum-processed,
said second processing chamber including
a loading unit (108) for supporting said workpiece to be vacuum-processed, and
an unloading unit (119) for supporting said workpiece having been vacuum-processed;
a gate unit (103) provided between said first opening and said second processing chamber in such a manner that said gate unit is attachable to and detachable from said first processing chamber,
said gate unit blocking and allowing communication between said first processing chamber and said second processing chamber connected via said gate unit;
a transport device (202) for loading said workpiece to be vacuum-processed from said loading unit to said vacuum processing unit through said first opening and said gate unit, and unloading said workpiece having been vacuum-processed from said vacuum processing unit to said unloading unit through said first opening and said gate unit; and
a movement mechanism (200) for separating said first processing chamber and said second processing chamber from each other.

2. The vacuum processing device according to claim 1, further comprising a base (201) for supporting said movement mechanism and said second processing chamber, wherein
said movement mechanism includes:
a wheel (203) attached to a lower portion of said first processing chamber; and
a rail (224) mounted on said base.

3. The vacuum processing device according to claim 1, wherein
said vacuum processing device further comprises at least one another first processing chamber (101b),
said movement mechanism separates said another first processing chamber and said second processing chamber from each other, and
said vacuum processing device further comprises a slide mechanism for sliding said another first processing chamber in a direction perpendicular to a direction in which said first processing chamber is moved by said movement mechanism.

4. The vacuum processing device according to claim 1, wherein
said first processing chamber includes a plurality of said vacuum processing units disposed in an arrangement direction perpendicular to a direction in which said workpiece is loaded into said first processing chamber,
said second processing chamber includes:
a plurality of said loading units disposed in said arrangement direction; and
a plurality of said unloading units disposed in said arrangement direction, and
an interval at which said plurality of loading units are arranged, an interval at which said plurality of unloading units are arranged, and an interval at which said plurality of vacuum processing units are arranged are substantially identical to each other.

5. The vacuum processing device according to claim 1, wherein
said first opening is formed at a place of connection to said gate unit and said first opening is sized larger than a cross section of said vacuum processing unit.

6. The vacuum processing device according to claim 1, wherein
said first processing chamber has a second opening (318) formed in a wall opposite to said first opening, and
said first processing chamber further includes a door (114a) for closing and opening said second opening.

7. The vacuum processing device according to claim 6, wherein
said second opening is sized larger than a cross section of said vacuum processing unit.

8. A vacuum processing factory (400) having the vacuum processing device of claim 1 disposed in the vacuum processing factory,
said vacuum processing factory defining:
a vacuum processing area (402) in which said first processing chamber and said second processing chamber connected via said gate unit are disposed; and
a maintenance area (401) in which said first processing chamber separated from said second processing chamber is disposed,
said first processing chamber for which maintenance is to be performed being moved to said maintenance area by said movement mechanism, and
said first processing chamber for which maintenance is completed being moved to said vacuum processing area by said movement mechanism.

9. A maintenance method for a vacuum processing device performing vacuum processing on a workpiece,
said vacuum processing device including:
a first processing chamber for receiving said workpiece through a first opening and housing said workpiece,
said first processing chamber including a vacuum processing unit for supporting said workpiece and performing vacuum processing on said workpiece;
an evacuatable second processing chamber for housing a workpiece to be vacuum-processed and a workpiece having been vacuum-processed,
said second processing chamber including
a loading unit for supporting said workpiece to be vacuum-processed, and
an unloading unit for supporting said workpiece having been vacuum-processed;
a gate unit provided between said first opening and said second processing chamber in such a manner that said gate unit is attachable to and detachable from said first processing chamber,
said gate unit blocking and allowing communication between said first processing chamber and said second processing chamber connected via said gate unit;
a transport device for loading said workpiece to be vacuum-processed from said loading unit to said vacuum processing unit through said first opening and said gate unit, and unloading said workpiece having been vacuum-processed from said vacuum processing unit to said unloading unit through said first opening and said gate unit; and
a movement mechanism for separating said first processing chamber and said second processing chamber from each other, and
said maintenance method comprising the steps of:
separating said first processing chamber and said second processing chamber from each other by using said movement mechanism;
performing maintenance of said first processing chamber; and
connecting said first processing chamber and said second processing chamber via said gate unit by using said movement mechanism.

10. The maintenance method according to claim 9, wherein
said vacuum processing device further includes at least one another first processing chamber,
said movement mechanism separates said another first processing chamber and said second processing chamber from each other,
said vacuum processing device further includes a slide mechanism for sliding said another first processing chamber in a direction perpendicular to a direction in which said first processing chamber is moved by said movement mechanism, and
said maintenance method further comprises the steps of:
separating said another first processing chamber and said second processing chamber from each other by using said movement mechanism;
sliding said another first processing chamber by using said slide mechanism; and
performing maintenance of said another first processing chamber.
